# EUROPEAN PATENT APPLICATION

(11) **EP 4 447 122 A2**
(43) Date of publication of application: **16.10.2024**
(21) Application number: 24158858.1
(22) Date of filing: 21.02.2024
(51) Int. Cl.: H01L 29/49, H10B 12/00

(54) **GATE STRUCTURE AND SEMICONDUCTOR DEVICE INCLUDING THE GATE STRUCTURE**

(30) Priority: 12.04.2023 KR 20230047878
(71) Applicant: Samsung Electronics Co., Ltd., Suwon-si, Gyeonggi-do 16677 (KR)
(72) Inventor: LYU, Sungnam, 16677 Suwon-si (KR); NOH, Hyojung, 16677 Suwon-si (KR); YANG, Minwoo, 16677 Suwon-si (KR); LEE, Byounghoon, 16677 Suwon-si (KR); JEONG, Eulji, 16677 Suwon-si (KR)
(74) Representative: Marks & Clerk LLP

(57) **Abstract**

A gate structure (99) may include a first conductive pattern (60), a second conductive pattern (80) on the first conductive pattern and including polysilicon doped with impurities, and a gate insulation pattern (45) on sidewalls of the first and second conductive patterns. A capping layer (70) including a semiconductor material or an insulating material may be disposed under the first conductive pattern. The first conductive pattern may include metal grains (65). At least one of the metal grains may extend from an upper surface of the capping layer to a lower surface of the second conductive pattern, and may contact the upper surface of the capping layer and the lower surface of the second conductive pattern.

## Description

### TECHNICAL FIELD

Example embodiments of the present disclosure relate to a gate structure and a method of forming the same, a semiconductor device including the gate structure and a method of manufacturing the same.

### DISCUSSION OF RELATED ART

In a dynamic random access memory (DRAM) device, as the size of a gate electrode decreases, a method of reducing the resistance of the gate electrode is desired. The gate electrode may include molybdenum instead of tungsten or titanium nitride in order to have a low resistance; however, it may still be desired to reduce the resistance of the gate electrode.

### SUMMARY

Example embodiments provide a gate structure having improved characteristics.

Example embodiments provide a semiconductor device including a gate structure having improved characteristics.

Example embodiments provide a method of forming a gate structure having improved characteristics.

Example embodiments provide a method of manufacturing a semiconductor device including a gate structure having improved characteristics.

According to example embodiments of the inventive concepts, there is provided a gate structure. The gate structure may include a first conductive pattern, a second conductive pattern on the first conductive pattern and including polysilicon doped with impurities, and a gate insulation pattern on sidewalls of the first and second conductive patterns. A capping layer including a semiconductor material or an insulating material may be disposed under the first conductive pattern. The first conductive pattern may include metal grains. At least one of the metal grains may extend from an upper surface of the capping layer to a lower surface of the second conductive pattern, and may contact the upper surface of the capping layer and the lower surface of the second conductive pattern.

According to example embodiments of the inventive concepts, there is provided a gate structure. The gate structure may include a first conductive pattern, a second conductive pattern including polysilicon doped with impurities on the first conductive pattern, and a gate insulation pattern on sidewalls of the first and second conductive patterns. A capping layer including a semiconductor material or an insulating material may be disposed under the first conductive pattern. A lower surface of the first conductive pattern may contact an upper surface of a protrusion portion of the capping layer.

According to example embodiments of the inventive concepts, there is provided a semiconductor device. The semiconductor device may include an active pattern, a gate structure, a bit line structure, a contact plug structure, and a capacitor structure. The active pattern may be disposed on a capping layer including a semiconductor material or an insulating material. The gate structure may be disposed in an upper portion of the active pattern, and may extend in a first direction substantially parallel to a lower surface of the capping layer. The bit line structure may extend in a second direction substantially parallel to the lower surface of the capping layer and substantially perpendicular to the lower surface of the capping layer, and may be disposed on a central portion of the active pattern. The contact plug structure may be disposed on each of opposite edge portions of the active pattern. The capacitor structure may be disposed on the contact plug structure. The gate structure may include a first conductive pattern, a second conductive pattern on the first conductive pattern and including polysilicon doped with impurities, a capping pattern on the second conductive pattern, and a gate insulation pattern on sidewalls of the first and second conductive patterns. The first conductive pattern may include metal grains. At least one of the metal grains may extend from an upper surface of the capping layer to a lower surface of the second conductive pattern, and may contact the upper surface of the capping layer and the lower surface of the second conductive pattern.

According to example embodiments of the inventive concepts, there is provided a method of forming a gate structure. In the method, a first recess may be formed on a substrate. A gate insulation layer may be formed on a bottom and a sidewall of the first recess. A first conductive pattern may be formed on the gate insulation layer in a lower portion of the first recess. A second conductive pattern may be formed on the first conductive pattern by a deposition process using the first conductive pattern as a seed. After overturning the substrate, an upper portion of the substrate and an upper portion of the gate insulation layer may be removed to expose the first conductive pattern. The first conductive pattern may be removed.

According to example embodiments of the inventive concepts, there is provided a method of forming a gate structure. In the method, a first recess may be formed on a substrate. A gate insulation layer may be formed on a bottom and a sidewall of the first recess. A first conductive pattern may be formed on the gate insulation layer in a lower portion of the first recess. A second conductive pattern may be formed on the first conductive pattern in a middle portion of the first recess by a deposition process using the first conductive pattern as a seed. A capping layer including a semiconductor material may be formed on the second conductive pattern in an upper portion of the first recess. The substrate and the gate insulation layer may be partially removed to expose the first conductive pattern. The first conductive pattern may be removed.

According to example embodiments of the inventive concepts, there is provided a method of manufacturing a gate structure. In the method, an upper portion of a substrate may be removed to form a first recess such that an active pattern may be defined on the substrate. An isolation pattern may be formed in the first recess. Upper portions of the active pattern and the isolation pattern may be removed to form a second recess. A gate insulation layer may be formed on a bottom and a sidewall of the second recess. A first conductive pattern may be formed on the gate insulation layer in a lower portion of the second recess. A second conductive pattern may be formed on the first conductive pattern by a deposition process using the first conductive pattern as a seed. After overturning the substrate, an upper portion of the substrate and an upper portion of the gate insulation layer may be removed to expose the first conductive pattern. The first conductive pattern may be removed to form a third recess. A third conductive pattern and a capping pattern may be sequentially formed in the third recess. A bit line structure electrically connected to a first portion of the active pattern may be formed. A capacitor electrically connected to a second portion of the active pattern may be formed.

The conductive pattern included in the gate electrode in accordance with example embodiments may include relatively large grains. The gate electrode may not include a seed pattern serving as a seed during the formation of the conductive pattern, and may not include a void therein. Thus, the gate electrode may have a relatively low resistance.

At least some of the above and other features of the invention are set out in the claims.

### BRIEF DESCRIPTION OF THE DRAWINGS

FIGS. 1A and 1B are cross-sectional views illustrating gate structures in accordance with example embodiments.
FIGS. 2 to 5 are cross-sectional views illustrating a method of forming a gate structure in accordance with example embodiments.
FIG. 6 is a plan view illustrating a semiconductor device in accordance with example embodiments.
FIG. 7 is a cross-sectional view taken along line A-A' of FIG. 6.
FIG. 8 is a cross-sectional view taken along line B-B' of FIG. 6.
FIGS. 9 to 28 are plan views and cross-sectional views illustrating a method of manufacturing a semiconductor device in accordance with example embodiments.

### DETAILED DESCRIPTION

The above and other aspects and features of a semiconductor device and a method of forming the same in accordance with example embodiments will become readily understood from detail descriptions that follow, with reference to the accompanying drawings. Like reference characters refer to like elements throughout.

It will be understood that, although the terms "first," "second," and/or "third" may be used herein to describe various materials, layers (films), regions, electrodes, pads, patterns, structures and processes, these materials, layers (films), regions, electrodes, pads, patterns, structures and processes should not be limited by these terms. These terms are only used to distinguish one material, layer (film), region, electrode, pad, pattern, structure and process from another material, layer (film), region, electrode, pad, pattern, structure and process. Thus, a first material, layer (film), region, electrode, pad, pattern, structure and process discussed below could be termed a second or third material, layer (film), region, electrode, pad, pattern, structure and process without departing from the teachings of inventive concepts.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise.

Spatially relative terms, such as "beneath," "below," "lower," "above," "upper" and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations) and the spatially relative descriptors used herein interpreted accordingly.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

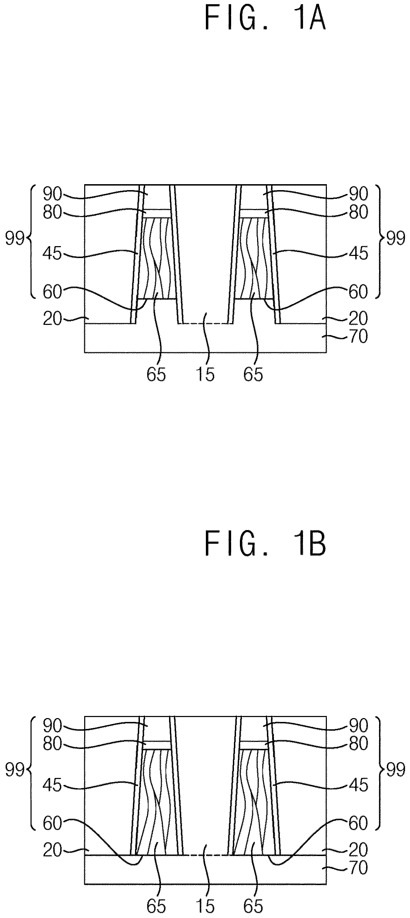

FIGS. 1A and 1B are cross-sectional views illustrating gate structures in accordance with example embodiments.

Referring to FIG. 1A, a gate structure 99 may include a gate electrode having second and third conductive patterns 60 and 80, a second capping pattern 90, and a gate insulation pattern 45.

The gate structure 99 may be formed on a first capping layer 70, and an active pattern 15 or an isolation pattern 20 may be formed on a sidewall of the gate structure 99. For example, the gate structure 99 may extend in a vertical direction through the active pattern 15 or the isolation pattern 20 on the first capping layer 70.

In example embodiments, the first capping layer 70 may include a semiconductor material, e.g., silicon, germanium, silicon-germanium, etc. Alternatively, the first capping layer 70 may include an insulating material, e.g., silicon nitride.

The active pattern 15 may be formed on the first capping layer 70, and the isolation pattern 20 may be formed on the first capping layer 70 to surround the active pattern 15. The active pattern 15 may include a semiconductor material, e.g., silicon, germanium, silicon-germanium, etc., and thus may be merged with the first capping layer 70 if the first capping layer 70 includes a semiconductor material. The isolation pattern 20 may include an oxide, e.g., silicon oxide.

The first capping layer 70 may include a protrusion portion that protrudes upwardly in the vertical direction, and the gate electrode and the second capping pattern 90 may be sequentially stacked on the protrusion portion. For example, the second conductive pattern 60 may be disposed on and may contact an upper surface of the first capping layer 70, the third conductive pattern 80 may be disposed on and may contact an upper surface of second conductive pattern 60, and the second capping pattern 90 may be disposed on and may contact an upper surface of the third conductive pattern 80. In example embodiments, a width in a horizontal direction of the gate electrode may gradually decrease in the vertical direction from a bottom toward a top thereof. The gate insulation pattern 45 may be formed on a sidewall of the protrusion portion of the first capping layer 70, a sidewall of the gate electrode and a sidewall of the second capping pattern 90. For example, the gate insulation pattern 45 may contact sidewalls of the protrusion portion of the first capping layer 70, the second conductive pattern 60, the third conductive pattern 80, and the second capping pattern 90. In example embodiments, the protrusion portion of the first capping layer 70 may be at a higher vertical level than a lower surface of the gate insulation pattern 45.

The second conductive pattern 60 may be formed of or include a low resistance material (e.g., molybdenum, tungsten, tantalum, aluminum, copper, ruthenium, etc.), a metal nitride (e.g., titanium nitride, tantalum nitride, lanthanum nitride, etc.), or a metal silicon nitride (e.g., titanium silicon nitride). The third conductive pattern 80 may be formed of or include, e.g., doped polysilicon.

The gate insulation pattern 45 may be formed of or include an oxide, e.g., silicon oxide or a metal oxide. The second capping pattern 90 may be formed of or include an insulating nitride, e.g., silicon nitride.

In example embodiments, the second conductive pattern 60 may include grains 65, each of which may extend in the vertical direction, spaced apart from each other in the horizontal direction. In example embodiments, some ones of the grains 65 included in the second conductive pattern 60 may not extend from a lower surface to an upper surface of the second conductive pattern 60, however, most ones or at least one of the grains 65 included in the second conductive pattern 60 may extend from the lower surface to the upper surface of the second conductive pattern 60. Thus, at least one of the grains 65 included in the second conductive pattern 60 may contact an upper surface of the protrusion portion of the first capping layer 70 and a lower surface of the third conductive pattern 80.

In an example embodiment, the second conductive pattern 60 may include only a single grain.

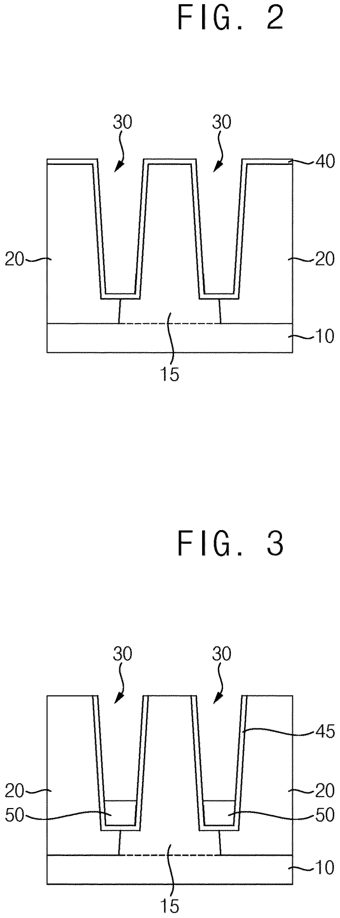

As illustrated below with reference to FIGS. 2 to 5, the second conductive pattern 60 may include a relatively small number of grains 65 having a relatively large size. Additionally, the second conductive pattern 60 may include no void therein, and a distribution of boundaries of the grains 65 may be small. Thus, the second conductive pattern 60 may have a relatively small resistance.

Furthermore, the gate electrode may not include a first conductive pattern 50 (refer to FIG. 3) having a relatively large resistance, which may serve as a seed for forming the second conductive pattern 60, and thus the gate electrode may have a relatively small resistance when compared to a gate electrode including the first conductive pattern 50.

Referring to FIG. 1B, the first capping layer 70 may include no protrusion portion that may protrude upwardly in the vertical direction, and thus an uppermost surface of the first capping layer 70 may be substantially coplanar with a lower surface of the active pattern 15 or the isolation pattern 20. Additionally, the gate insulation pattern 45 may not be formed on the sidewall of the protrusion portion, but may be formed only on the sidewall of the gate electrode and the sidewall of the second capping pattern 90. For example, a lower surface of the gate insulation pattern 45 may be coplanar with a lower surface of the second conductive pattern 60. In this case, not only a horizontal width of the gate electrode but also a horizontal width of the gate structure 99 may gradually decrease from a bottom toward a top thereof.

FIGS. 2 to 5 are cross-sectional views illustrating a method of forming a gate structure in accordance with example embodiments.

Referring to FIG. 2, an upper portion of a substrate 10 may be removed to form a first recess, and an isolation pattern 20 may be formed to fill the first recess.

As the first recess is formed, an active pattern 15 may be defined on the substrate 10, and a sidewall of the active pattern 15 may be covered by the isolation pattern 20.

The active pattern 15 and the isolation pattern 20 on the substrate 10 may be partially etched to form second recesses 30, and a gate insulation layer 40 may be formed on a bottom and a sidewall of the second recesses 30 and upper surfaces of the active pattern 15 and the isolation pattern 20.

In an example embodiment, the second recesses 30 may have a width gradually decreasing from a top toward a bottom thereof.

Referring to FIG. 3, a first conductive layer may be formed on the gate insulation layer 40 to fill the second recesses 30, and an upper portion of the first conductive layer may be removed to form a first conductive pattern 50 in a lower portion of each of the second recesses 30.

The first conductive layer may be formed by a deposition process, e.g., a chemical vapor deposition (CVD) process, an atomic layer deposition (ALD) process, etc., and the upper portion of the first conductive layer may be removed by, e.g., a chemical mechanical polishing (CMP) process and an etch-back process.

In example embodiments, the CMP process on the first conductive layer may be performed until the upper surfaces of the active pattern 15 and the isolation pattern 20 are exposed, and thus a portion of the gate insulation layer 40 on the active pattern 15 and the isolation pattern 20 may be removed so that a gate insulation pattern 45 may be formed on the bottom and the sidewall of the second recess 30.

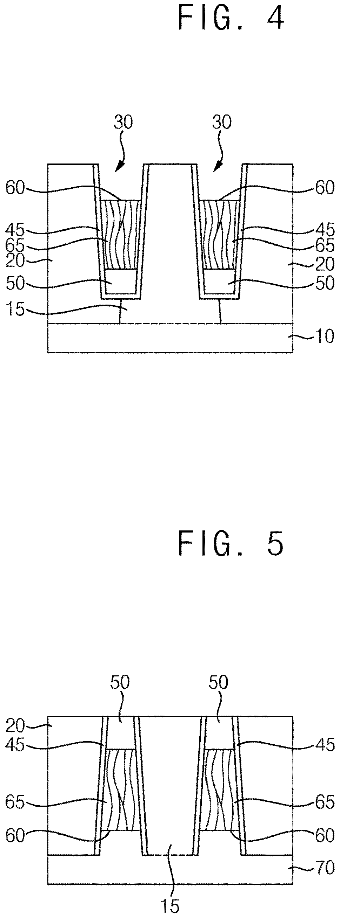

Referring to FIG. 4, a second conductive pattern 60 may be formed on the first conductive pattern 50.

The second conductive pattern 60 may be formed by performing a deposition process, e.g., a CVD process, an ALD process, etc., on the first conductive pattern 50, the gate insulation pattern 45, the active pattern 15 and the isolation pattern 20 to form a second conductive layer, and removing an upper portion of the second conductive layer through, e.g., a CMP process and/or an etch-back process.

In an example embodiment, the second conductive pattern 60 may be formed in a middle portion of the second recess 30, and thus an upper surface of the second conductive pattern 60 may be lower than the upper surfaces of the active pattern 15 and the isolation pattern 20. Alternatively, the upper surface of the second conductive pattern 60 may be substantially coplanar with the upper surfaces of the active pattern 15 and the isolation pattern 20.

In example embodiments, the second conductive layer may be formed by using the first conductive pattern 50 as a seed during the deposition process, and the first conductive pattern 50 is formed only in the lower portion of the second recess 30 so that the second conductive layer may be deposited only in the vertical direction from the upper surface of the first conductive pattern 50.

Accordingly, the second conductive pattern 60 may be formed to include grains 65, each of which may extend in the vertical direction, arranged in the horizontal direction. In example embodiments, some ones of the grains 65 included in the second conductive pattern 60 may not extend from a lower surface to an upper surface of the second conductive pattern 60, however, most ones or at least one of the grains 65 included in the second conductive pattern 60 may extend from the lower surface to the upper surface of the second conductive pattern 60.

In an example embodiment, the second conductive pattern 60 may include only a single grain.

If the first conductive pattern 50 serving as the seed in the deposition process for forming the second conductive layer is formed not in the lower portion of the second recess 30 only, but conformally formed on the bottom and the sidewall of the second recess 30, the second conductive layer may be formed in the horizontal direction and the vertical direction from a portion of the first conductive pattern 50 on the sidewall of the second recess 30 as well as a portion of the first conductive pattern 50 on the bottom of the second recess 30. Thus, grains of the second conductive layer may be formed without a certain orientation instead of being formed in the vertical direction, and may have small sizes. Additionally, voids may be formed between the grains of the second conductive pattern 60, and boundaries of the grains may have irregular distribution. Accordingly, the second conductive pattern 60 including the grains may have a large resistance.

However, in example embodiments, the second conductive pattern 60 may include the grains 65 that may extend in the vertical direction, and the number of the grains may be small and the sizes of the grains may be large. Additionally, there is no void in the second conductive pattern 60, and thus the distribution of the boundaries of the grains 65 may be small. Accordingly, the second conductive pattern 60 may have a relatively low resistance.

Referring to FIG. 5, a first capping layer 70 may be formed on the second conductive pattern 60, the gate insulation pattern 45, the active pattern 15 and the isolation pattern 20 to fill a remaining portion of the second recess 30.

In example embodiments, the first capping layer 70 may be formed of or include a material substantially the same as that of the active pattern 15, e.g., silicon, germanium, silicon-germanium, etc., and thus may be merged with the active pattern 15.

The substrate 10 may be overturned (e.g., rotated 180°) so that a lower surface of the substrate 10 may face upwardly, and the substrate 10, the active pattern 15, the isolation pattern 20 and the gate insulation pattern 45 may be partially removed by, e.g., a grinding process, a CMP process, etc., until the first conductive pattern 50 is exposed.

Referring back to FIGS. 1A and 1B, the exposed first conductive pattern 50 may be removed to form a third recess, and a third conductive pattern 80 and the second capping pattern 90 may be sequentially stacked in the third recess.

Accordingly, a gate electrode including the second conductive pattern 60 and the third conductive pattern 80 sequentially stacked in the vertical direction may be formed, and the gate electrode, the second capping pattern 90 and the gate insulation pattern 45 may collectively form a gate structure 99.

As illustrated above, the first conductive pattern 50 may be formed only in the lower portion of the second recess 30, and the second conductive pattern 60 may be formed in the second recess 30 by a deposition process using the first conductive pattern 50 as a seed, so that the second conductive pattern 60 may be deposited only in the vertical direction from the upper surface of the first conductive pattern 50.

Accordingly, each of the grains 65 included in the second conductive pattern 60 may extend in the vertical direction, and may have a relatively large size when compared to a grain of a conductive pattern that is deposited in the horizontal direction as well as in the vertical direction. Additionally, the distribution of the boundaries of the grains 65 may be small, and the second conductive pattern 60 may not include a void therein. As a result, the second conductive pattern 60 may have a relatively small resistance.

After the substrate 10 is overturned, the active pattern 15 and the isolation pattern 20 on the first conductive pattern 50 may be removed to expose the first conductive pattern 50, and the first conductive pattern 50 may be removed. Accordingly, the gate electrode may not include the first conductive pattern 50, may include only the second and third conductive patterns 60 and 80. The first conductive pattern 50 may include a conductive material serving as a seed for forming the second conductive pattern 60, and may have a resistance greater than that of the second conductive pattern 60. Accordingly, the gate electrode not including the first conductive pattern 50 may have a relatively small resistance when compared to a gate electrode including the first conductive pattern 50.

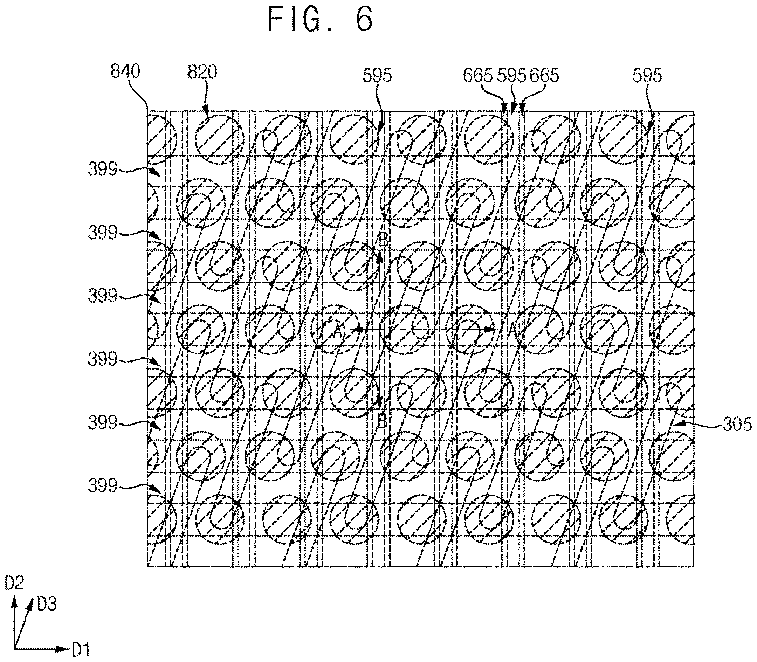

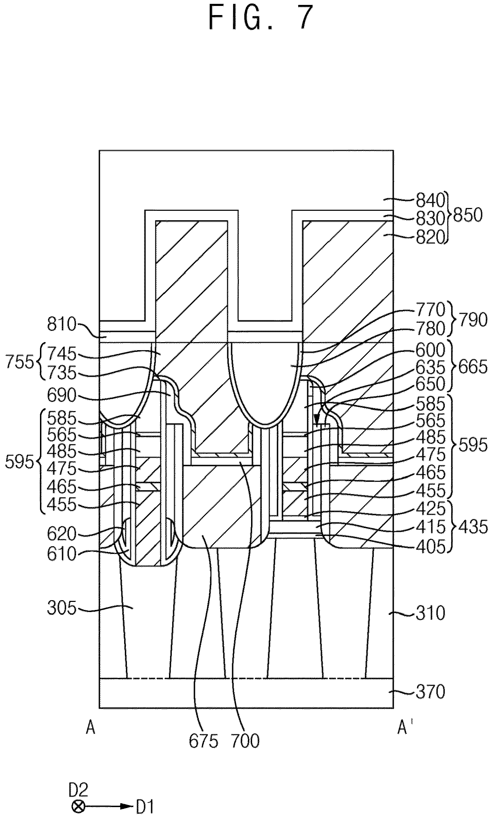

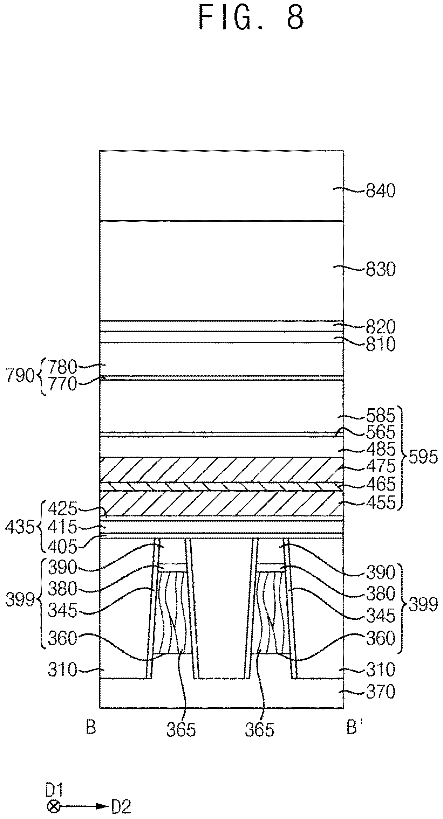

FIG. 6 is a plan view illustrating a semiconductor device in accordance with example embodiments, FIG. 7 is a cross-sectional view taken along line A-A' of FIG. 6, and FIG. 8 is a cross-sectional view taken along line B-B' of FIG. 6.

This semiconductor device may be a dynamic random access memory (DRAM) device to which the gate structure of FIG. 1A is applied, and thus repeated explanations on the gate structure are omitted herein. However, this semiconductor device may include the gate structure of FIG. 1B.

Hereinafter, two directions among horizontal directions that are substantially parallel to a lower surface of a first capping layer 370, which may be substantially perpendicular to each other, may be referred to as first and second directions D1 and D2, and a direction among the horizontal direction, which may have an acute angle with respect to the first and second directions D1 and D2, may be referred to as a third direction D3. A direction substantially perpendicular to the lower surface of the first capping layer 370 may be referred to as a vertical direction. It will be understood that the directions D 1, D2 and D3 are example directions, expressed relative to the device without implying any particular orientation of the device.

The semiconductor device may include an active pattern 305, a gate structure 399, and a bit line structure 595.

Additionally, the semiconductor device may further include an isolation pattern 310, a contact plug structure and a capacitor 850 on the first capping layer 370.

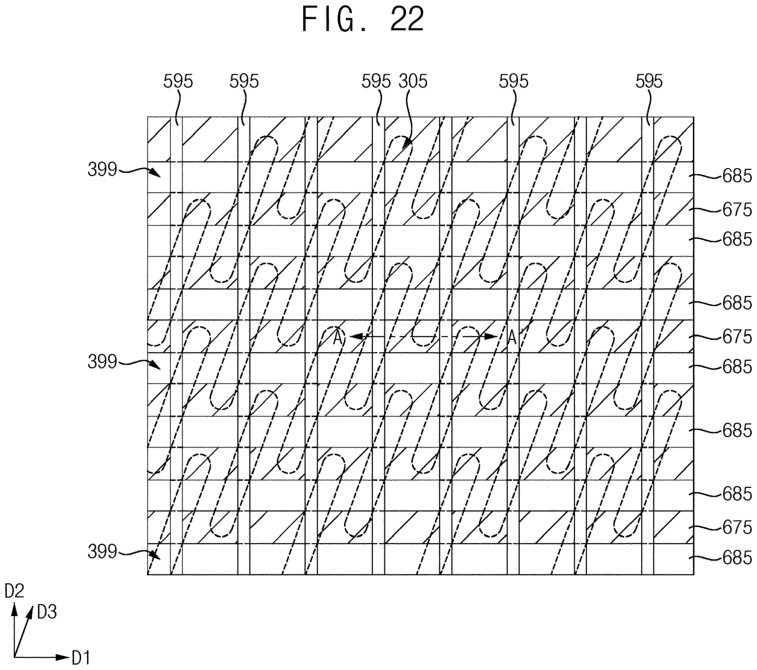

Additionally, the semiconductor device may further include a spacer structure 665, a fourth spacer 690, a fence pattern 685 (refer to FIG. 22), first and second insulation pattern structures 435 and 790, fourth and fifth insulation patterns 610 and 620, and a metal silicide pattern 700.

The active pattern 305 may be formed on a substrate 300, and an isolation pattern 112 may be formed to cover a sidewall of the active pattern 305.

A plurality of active patterns 305 may be spaced apart from each other in the first and second directions D1 and D2 on the first capping layer 370. The isolation pattern 310 may be formed on the first capping layer 370, and may cover a sidewall of the active pattern 305. The isolation pattern 310 may contact the first capping layer 370 and the sidewall of the active pattern 305. The first capping layer 370 and the active pattern 305 may include a semiconductor material, and the isolation pattern 310 may include an oxide, e.g., silicon oxide. Alternatively, the first capping layer 370 may include an insulating nitride, e.g., silicon nitride.

The gate structure 399 may extend lengthwise through the active pattern 305 and the isolation pattern 310 in the first direction D1, and a plurality of gate structures 399 may be spaced apart from each other in the second direction D2. In example embodiments, two gate structures 399 spaced apart from each other in the second direction D2 may extend through a single active pattern 305.

The gate structure 399 may include a gate electrode and a second capping pattern 390 sequentially stacked in the vertical direction on a protrusion portion of the first capping layer 370 and a gate insulation pattern 345 on sidewalls of the gate electrode and the second capping pattern 390, and the gate electrode may include second and third conductive patterns 360 and 380.

In example embodiments, the gate structure 399 may extend lengthwise in the first direction D1. A horizontal width of the gate electrode of the gate structure 399 may gradually decrease from a bottom toward a top thereof.

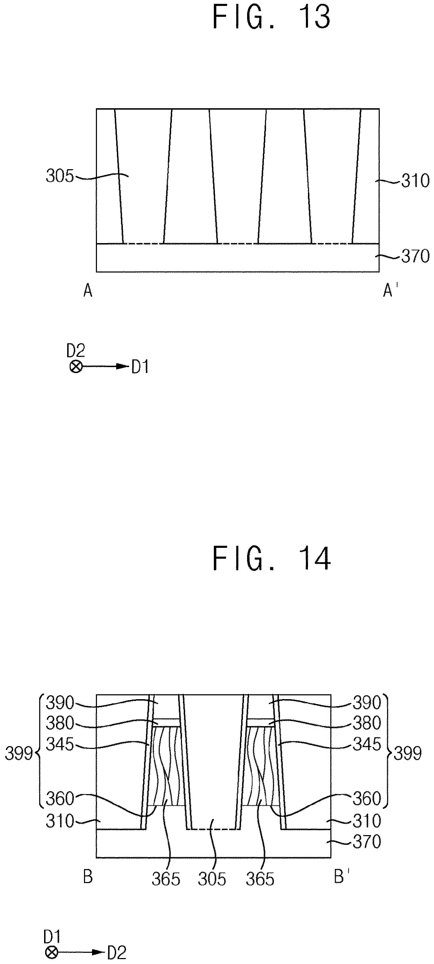

Referring to FIGS. 6 to 8 together with FIGS. 14 to 16, a first opening 440 extending through the insulation layer structure 430 to expose upper surfaces of the active pattern 305, the isolation pattern 310 and the second capping pattern 390 of the gate structure 399 may be formed, and an upper surface of a central portion of the active pattern 305 in the third direction D3 may be exposed by the first opening 440.

In example embodiments, an area of a bottom of the first opening 440 may be greater than an area of the upper surface of the active pattern 305 exposed by the first opening 440. Thus, the first opening 440 may also expose the upper surface of the isolation pattern 310 adjacent to the active pattern 305. Additionally, the first opening 440 may extend through an upper portion of the active pattern 305 and an upper portion of the isolation pattern 310 adjacent thereto, and thus a bottom of the first opening 440 may be lower than an upper surface of a portion of the active pattern 305 on which the first opening 440 is not formed, that is, an upper surface of an end portion in the third direction D3 of the active pattern 305.

The bit line structure 595 may include a fourth conductive pattern 455, a first barrier pattern 465, a fifth conductive pattern 475, a first mask 485, a first etch stop pattern 565, and a third capping pattern 585 sequentially stacked in the vertical direction on the first opening 440 or on the first insulation pattern structure 435. The fourth conductive pattern 455, the first barrier pattern 465, and the fifth conductive pattern 475 may collectively form a conductive structure, and the first mask 485, the first etch stop pattern 565, and the third capping pattern 585 may collectively form an insulation structure.

The fourth conductive pattern 455 may be formed of or include, e.g., doped polysilicon, the first barrier pattern 465 may be formed of or include a metal nitride, e.g., titanium nitride, or a metal silicon nitride, e.g., titanium silicon nitride, the fifth conductive pattern 475 may be formed of or include a metal, e.g., tungsten, and each of the first mask 485, the first etch stop pattern 565, and the third capping pattern 585 may be formed of or include an insulating nitride, e.g., silicon nitride.

In example embodiments, the bit line structure 595 may extend lengthwise in the second direction D2 on the substrate 300, and a plurality of bit line structures 595 may be spaced apart from each other in the first direction D 1.

The fourth and fifth insulation patterns 610 and 620 may be formed on the first opening 440, and may contact a lower sidewall of the bit line structure 595. The fourth insulation pattern 610 may be formed of or include an oxide, e.g., silicon oxide, and the fifth insulation pattern 620 may be formed of or include an insulating nitride, e.g., silicon nitride.

The first insulation pattern structure 435 may be formed under the bit line structure 595 on the active pattern 305 and the isolation pattern 310, and may include first, second, and third insulation patterns 405, 415, and 425 sequentially stacked in the vertical direction. The first and third insulation patterns 405 and 425 may be formed of or include an oxide, e.g., silicon oxide, and the second insulation pattern 415 may be formed of or include an insulating nitride, e.g., silicon nitride.

The contact plug structure may include a lower contact plug 675, a metal silicide pattern 700, and an upper contact plug 755 sequentially stacked on the active pattern 305 and the isolation pattern 310 in the vertical direction.

The lower contact plug 675 may contact the upper surface of each of opposite end portions in the third direction D3 of the active pattern 305. In example embodiments, a plurality of lower contact plugs 675 may be spaced apart from each other in the second direction D2 between neighboring ones of the bit line structures 595 in the first direction D1, and the fence pattern 685 may be formed between neighboring ones of the lower contact plugs 675 in the second direction D2. The fence pattern 685 may be formed of or include an insulating nitride, e.g., silicon nitride.

The lower contact plug 675 may be formed of or include, e.g., doped polysilicon, and the metal silicide pattern 700 may be formed of or include, e.g., titanium silicide, cobalt silicide, nickel silicide, etc.

The upper contact plug 755 may include a second metal pattern 745 and a second barrier pattern 735 covering a lower surface of the second metal pattern 745. The second barrier pattern 735 may contact the lower surface of the second metal pattern 745. The second metal pattern 745 may be formed of or include a metal, e.g., tungsten, and the second barrier pattern 735 may be formed of or include a metal nitride, e.g., titanium nitride.

In example embodiments, a plurality of upper contact plugs 755 may be spaced apart from each other in the first and second directions D 1 and D2, and may be arranged in a honeycomb pattern or a lattice pattern in a plan view. Each of the upper contact plugs 755 may have a shape of, e.g., a circle, an ellipse, or a polygon in a plan view.

The spacer structure 665 may include a first spacer 600 covering a sidewall of the bit line structure 595 and a sidewall of the third insulation pattern 425, an air spacer 635 on a lower outer sidewall of the first spacer 600, and a third spacer 650 covering an outer sidewall of the air spacer 635, a sidewall of the first insulation pattern structure 435, and upper surfaces of the fourth and fifth insulation patterns 610 and 620.

Each of the first and third spacers 600 and 650 may be formed of or include an insulating nitride, e.g., silicon nitride, and the air spacer 635 may include air. The term "air" as discussed herein, may refer to atmospheric air, or other gases that may be present during the manufacturing process.

The fourth spacer 690 may be formed on an outer sidewall of a portion of the first spacer 600 on an upper sidewall of the bit line structure 595, and may cover a top of the air spacer 635 and an upper surface of the third spacer 650. The fourth spacer 690 may be formed of or include an insulating nitride, e.g., silicon nitride.

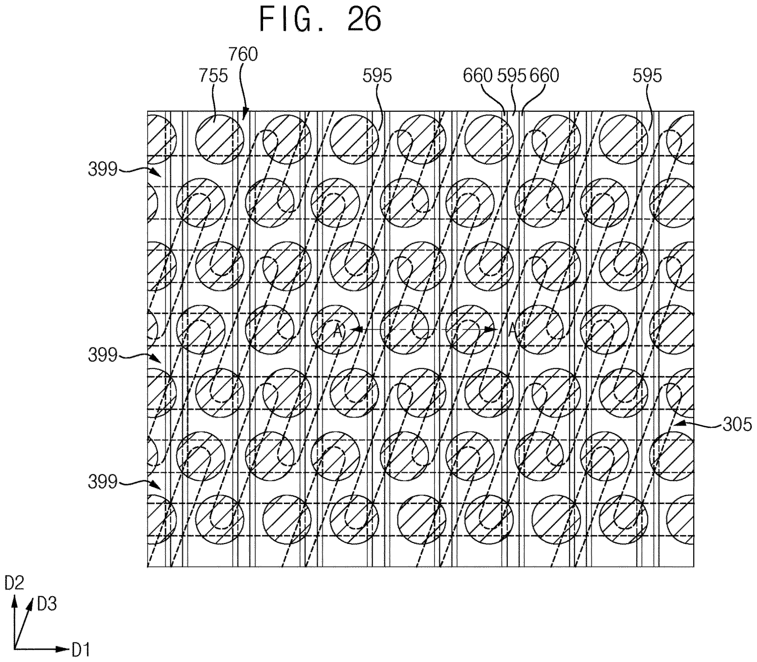

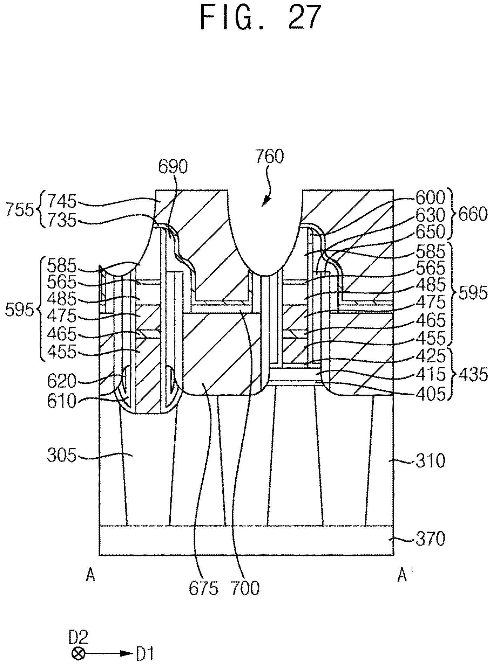

Referring to FIGS. 6 to 8 together with FIGS. 26 and 27, the second insulation pattern structure 790 may include a sixth insulation pattern 770 and a seventh insulation pattern 780. The sixth insulation pattern 770 may be formed on an inner wall of a sixth opening 760 extending through the upper contact plug 755, a portion of the insulation structure included in the bit line structure 595, and portions of the first, third, and fourth spacers 600, 650, and 690 to surround the upper contact plug 755 in a plan view. The seventh insulation pattern 780 may be formed on the sixth insulation pattern 770, and may fill a remaining portion of the sixth opening 760. The top of the air spacer 635 may be closed by the sixth insulation pattern 770.

The sixth and seventh insulation patterns 770 and 780 may be formed of or include an insulating nitride, e.g., silicon nitride.

The second etch stop layer 810 may be formed on the second insulation pattern structure 790, the upper contact plug 755, and the fence pattern 685, and a lower electrode 820 included in the capacitor 850 may extend through the second etch stop layer 810 to contact an upper surface of the upper contact plug 755. A dielectric layer 830 may be formed on an upper surface of a lower electrode 820, and an upper electrode 840 may be formed on the dielectric layer 830. The lower electrode 820, the dielectric layer 830, and the upper electrode 840 may form a capacitor 850.

The semiconductor device may include the gate structure 399, and the gate electrode included in the gate structure 399 may not include the first conductive pattern serving as a seed for forming the second conductive pattern 360 and having a relatively large resistance, so as to have a relatively small resistance. Additionally, the second conductive pattern 360 may include grains 365 having a relatively large size and may include no void therein, so as to have a relatively small resistance.

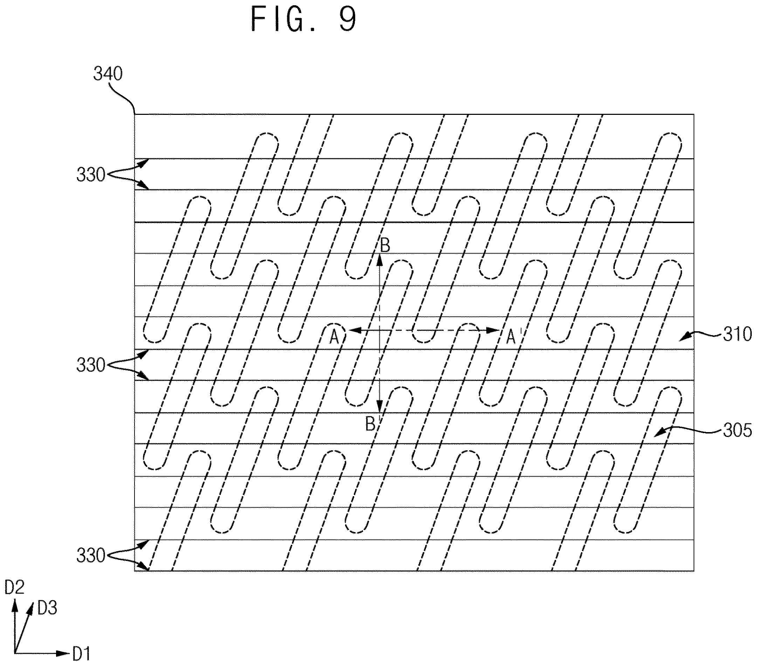

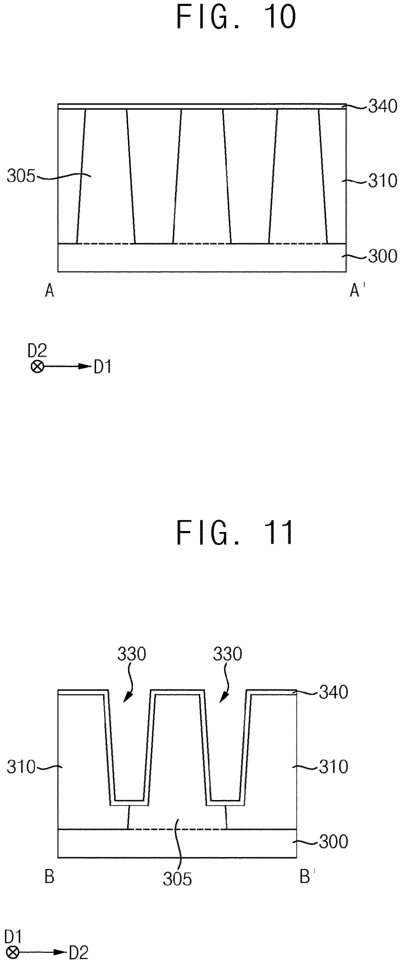

FIGS. 9 to 28 are plan views and cross-sectional views illustrating a method of manufacturing a semiconductor device in accordance with example embodiments. Particularly, FIGS. 9, 12, 15, 18, 22, and 26 are the plan views, FIGS. 10, 13, 16-17, 19-21, 23-25, and 27-28 are cross-sectional views taken along lines A-A' of corresponding plan views, respectively, and FIGS. 11 and 14 are cross-sectional views taken along lines B-B' of corresponding plan views, respectively.

This method may be an application of the manufacturing method illustrated with reference to FIGS. 2 to 5 and FIG. 1 to a method of manufacturing a DRAM device, and repeated explanations are omitted herein.

Referring to FIGS. 9 to 11, an upper portion of a substrate 300 may be removed to form a first recess, and an isolation pattern 310 may be formed in the first recess.

As the first recess is formed on the substrate 300, an active pattern 305 may be defined on the substrate 300, and a sidewall of the active pattern 305 may be covered by the isolation pattern 310.

The active pattern 305 and the isolation pattern 310 on the substrate 300 may be partially etched to form a second recess 330 extending lengthwise in the first direction D1, and a gate insulation layer 340 may be formed on a bottom and a sidewall of the second recess 330 and upper surfaces of the active pattern 305 and the isolation pattern 310.

In example embodiments, a plurality of second recesses 330 may be spaced apart from each other in the second direction D2, and two second recesses 330 may be formed in a single active pattern 305. In an example embodiment, the second recess 330 may have a width gradually decreasing from a top toward a bottom thereof.

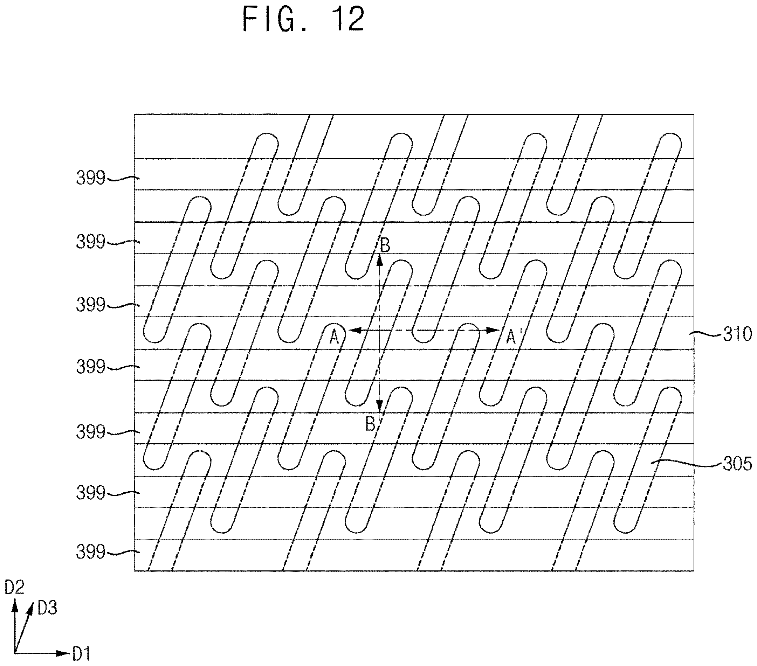

Referring to FIGS. 12 to 14, processes substantially the same as those illustrated with reference to FIGS. 3 to 5 and FIG. 1 may be performed to form a gate structure 399 and a first capping layer 370.

For example, a first conductive pattern may be formed in a lower portion of the second recess 330, a second conductive pattern 360 may be formed on the first conductive pattern, and the first capping layer 370 may be formed on the second conductive pattern 360, the gate insulation pattern 345, the active pattern 305 and the isolation pattern 310. After overturning the substrate 300, the substrate 300, the active pattern 305, the isolation pattern 310, and the gate insulation pattern 345 may be partially removed until the first conductive pattern is exposed to form a third recess, and a third conductive pattern 380 and a second capping pattern 390 may be sequentially stacked in the third recess.

Thus, the gate structure 399 including a gate electrode and the second capping pattern 390 sequentially stacked in the vertical direction on a protrusion portion of the first capping layer 370, and the gate insulation pattern 345 on sidewalls of the protrusion portion of the first capping layer 370, the gate electrode and the second capping pattern 390 may be formed. The gate electrode may include the second and third conductive patterns 360 and 380 sequentially stacked in the vertical direction.

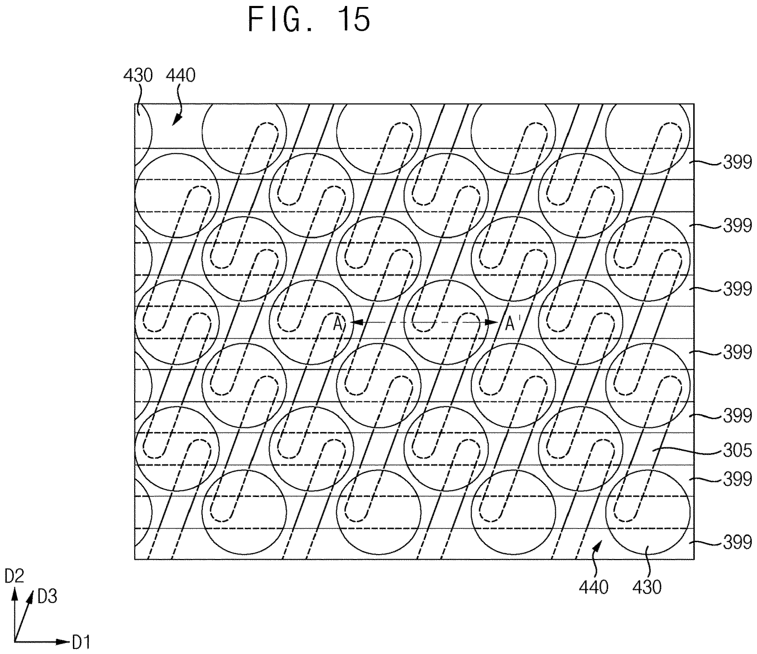

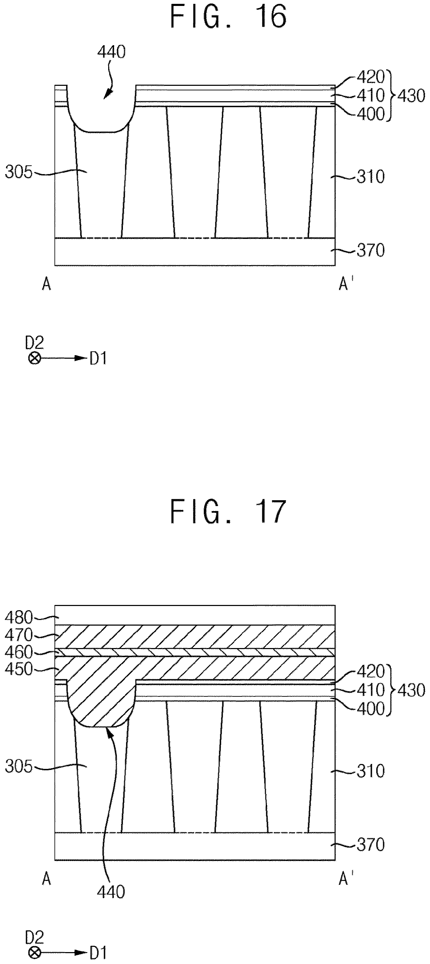

Referring to FIGS. 15 and 16, an insulation layer structure 430 may be formed on the active pattern 305, the isolation pattern 310, and the gate structure 399.

The insulation layer structure 430 may include first, second and third insulation layers 400, 410, and 420 sequentially stacked in the vertical direction.

The insulation layer structure 430 may be patterned, and the active pattern 305, the isolation pattern 310, and the second capping pattern 390 of the gate structure 399 may be partially etched by an etching process using the patterned insulation layer structure 430 as an etching mask to form a first opening 440. In example embodiments, the insulation layer structure 430 remaining after the etching process may have a shape of, e.g., a circle or an ellipse in a plan view, and a plurality of insulation layer structures 430 may be spaced apart from each other in the first and second directions D1 and D2. Each of the insulation layer structures 430 may overlap edge portions in the third direction D3 of neighboring active patterns 305, respectively.

Referring to FIG. 17, a fourth conductive layer 450, a first barrier layer 460, a fifth conductive layer 470, and a first mask layer 480 may be sequentially stacked on the insulation layer structure 430, and the active pattern 305, the isolation pattern 310, and the gate structure 399 exposed by the first opening 440, which may collectively form a conductive layer structure. The fourth conductive layer 450 may fill the first opening 440.

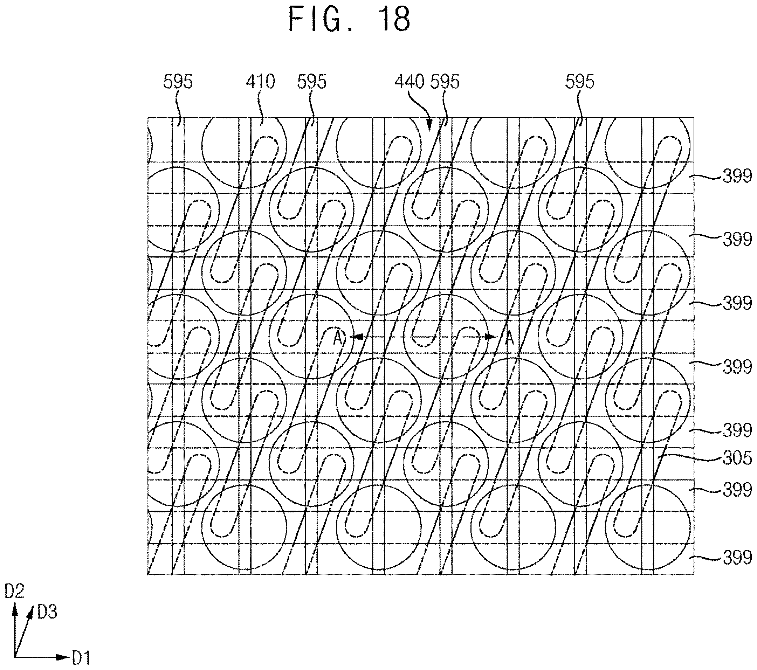

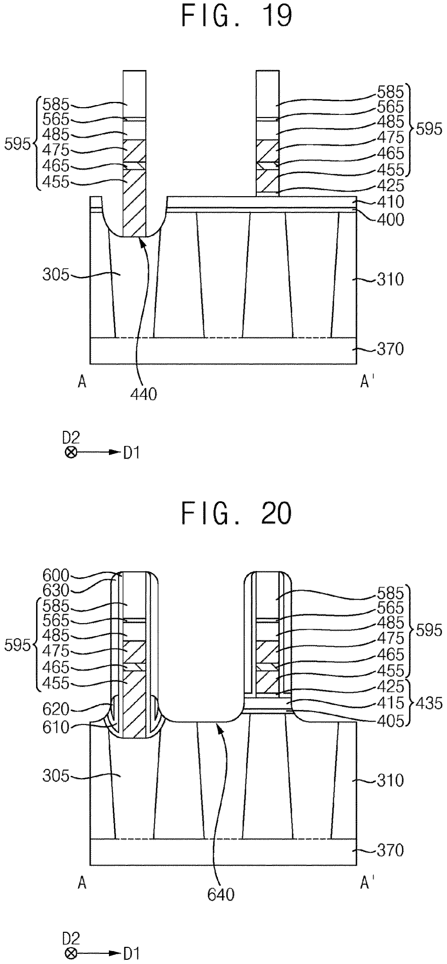

Referring to FIGS. 18 and 19, a first etch stop layer and a third capping layer may be sequentially stacked on the conductive layer structure, and the third capping layer may be etched to form a third capping pattern 585.

The first etch stop layer, the first mask layer 480, the fifth conductive layer 470, the first barrier layer 460 and the fourth conductive layer 450 may be sequentially etched by an etching process using the third capping pattern 585 as an etching mask.

In example embodiments, the third capping pattern 585 may extend lengthwise in the second direction D2, and a plurality of third capping patterns 585 may be spaced apart from each other in the first direction D 1.

By the etching process, a fourth conductive pattern 455, a first barrier pattern 465, a fifth conductive pattern 475, a first mask 485, a first etch stop pattern 565, and the third capping pattern 585 may be sequentially stacked on the first opening 440, and a third insulation pattern 425, the fourth conductive pattern 455, the first barrier pattern 465, the fifth conductive pattern 475, the first mask 485, the first etch stop pattern 565, and the third capping pattern 585 may be sequentially stacked on the second insulation layer 410 of the insulation layer structure 430 at an outside of the first opening 440.

Hereinafter, the fourth conductive pattern 455, the first barrier pattern 465, the fifth conductive pattern 475, the first mask 485, the first etch stop pattern 565 and the third capping pattern 585 sequentially stacked may be referred to as a bit line structure 595. The fourth conductive pattern 455, the first barrier pattern 465, and the fifth conductive pattern 475 may collectively form a conductive structure, and the first mask 485, the first etch stop pattern 565 and the third capping pattern 585 may collectively form an insulation structure. In example embodiments, the bit line structure 595 may extend lengthwise in the second direction D2 on the substrate 300, and a plurality of bit line structures 595 may be spaced apart from each other in the first direction D1.

Referring to FIG. 20, a first spacer layer may be formed on the substrate 300 having the bit line structure 595, and fourth and fifth insulation layers may be sequentially formed on the first spacer layer.

The first spacer layer may also cover a sidewall of the third insulation pattern 425 under a portion of the bit line structure 595 on the second insulation layer 410, and the fifth insulation layer may fill a remaining portion of the first opening 440.

The fourth and fifth insulation layers may be etched by an etching process. In example embodiments, the etching process may be performed by a wet etching process using an etching solution, e.g., H₂PO₃, SC1, HF, etc., and portions of the fourth and fifth insulation layers at the outside of the first opening 440 may be removed. Thus, a portion of the first spacer layer at the outside of the first opening 440 may be exposed, and portions of the fourth and fifth insulation layers in the first opening 440 may form fourth and fifth insulation patterns 610 and 620, respectively.

A second spacer layer may be formed on the exposed portion of the first spacer layer and the fourth and fifth insulation patterns 610 and 620 in the first opening 440, and may be anisotropically etched to form a second spacer 630 on the exposed portion of the first spacer and the fourth and fifth insulation patterns 610 and 620 to cover a sidewall of the bit line structure 595.

A dry etching process may be performed using the third capping pattern 585 and the second spacer 630 as an etching mask to form a second opening 640 exposing an upper surface of the active pattern 305, and upper surfaces of the isolation pattern 310 and the second capping pattern 390 may also be exposed by the second opening 640.

By the dry etching process, a portion of the first spacer layer on the third capping pattern 585 and the second insulation layer 410 may be removed, and thus a first spacer 600 covering a sidewall of the bit line structure 595 may be formed. Additionally, by the dry etching process, the first and second insulation layers 400 and 410 may also be partially etched so that first and second insulation patterns 405 and 415 may remain under the bit line structure 595. The first to third insulation patterns 405, 415, and 425 sequentially stacked under the bit line structure 595 may collectively form a first insulation pattern structure 435.

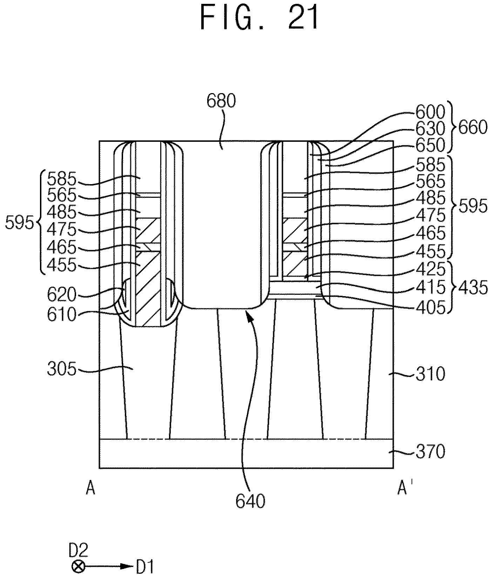

Referring to FIG. 21, a third spacer layer may be formed on an upper surface of the third capping pattern 585, an outer sidewall of the second spacer 630, upper surfaces of the fourth and fifth insulation patterns 610 and 620, and the upper surfaces of the active pattern 305, the isolation pattern 310, and the second capping pattern 390 exposed by the second opening 640, and may be anisotropically etched to form a third spacer 650 on the sidewall of the bit line structure 595.

The first, second, and third spacers 600, 630, and 650 sequentially stacked on the sidewall of the bit line structure 595 may collectively form a preliminary spacer structure 660.

A sacrificial layer may be formed on the substrate 300 to fill the second opening 640, and may be planarized until the upper surface of the third capping pattern 585 is exposed to form a sacrificial pattern 680 in the second opening 640.

In example embodiments, the sacrificial pattern 680 may extend in the second direction D2, and a plurality of sacrificial patterns 680 may be spaced apart from each other in the first direction D1 by the bit line structures 595. The sacrificial pattern 680 may be formed of or include an oxide, e.g., silicon oxide.

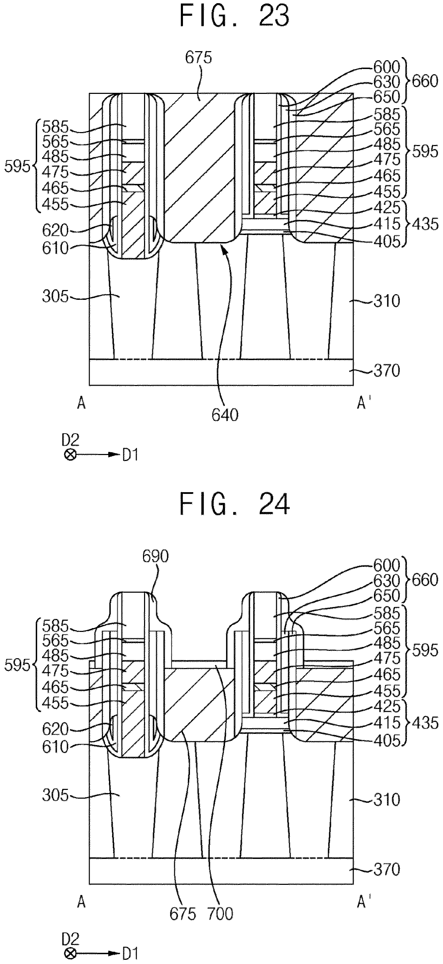

Referring to FIGS. 22 and 23, a second mask including a plurality of third openings, each of which may extend in the first direction D 1, spaced apart from each other in the second direction D2 may be formed on the third capping pattern 585, the sacrificial pattern 680 and the preliminary spacer structure 660, and the sacrificial pattern 680 may be etched by an etching process using the second mask as an etching mask.

In example embodiments, each of the third openings may overlap in the vertical direction an area between the gate structures 399. By the etching process, a fourth opening exposing upper surfaces of the active pattern 305 and the isolation pattern 310 may be formed between the bit line structures 595.

After removing the second mask, a lower contact plug layer may be formed to fill the fourth opening, and may be planarized until upper surfaces of the third capping pattern 585, the sacrificial pattern 680, and the preliminary spacer structure 660 are exposed. Thus, the lower contact plug layer may be divided into a plurality of lower contact plugs 675 spaced apart from each other in the second direction D2 between the bit line structures 595. Additionally, the sacrificial pattern 680 extending in the second direction D2 between the bit line structures 595 may be divided into a plurality of parts spaced apart from each other in the second direction D2 by the lower contact plugs 675.

The sacrificial pattern 680 may be removed to form a fifth opening, and a fence pattern 685 may be formed in the fifth opening. In example embodiments, the fence pattern 685 may overlap the gate structure 399 in the vertical direction.

Referring to FIG. 24, an upper portion of the lower contact plug 675 may be removed to expose an upper portion of the preliminary spacer structure 660 on the sidewall of the bit line structure 595, and upper portions of the second and third spacers 630 and 650 of the preliminary spacer structure 660 may be removed.

An upper portion of the lower contact plug 675 may be further removed. Thus, an upper surface of the lower contact plug 675 may be lower than upper surfaces of the second and third spacers 630 and 650.

A fourth spacer layer may be formed on the bit line structure 595, the preliminary spacer structure 660, the fence pattern 685, and the lower contact plug 675, and may be anisotropically etched to form a fourth spacer 690 covering an upper portion of the preliminary spacer structure 660 on each of opposite sidewalls in the first direction D 1 of the bit line structure 595, and thus an upper surface of the lower contact plug 675 may be exposed.

A metal silicide pattern 700 may be formed on the upper surface of the lower contact plug 675. In example embodiments, the metal silicide pattern 700 may be formed by forming a first metal layer on the third capping patterns 585, the fence pattern 685, the fourth spacer 690, and the lower contact plug 675, performing a heat treatment process, and removing an unreacted portion of the first metal layer.

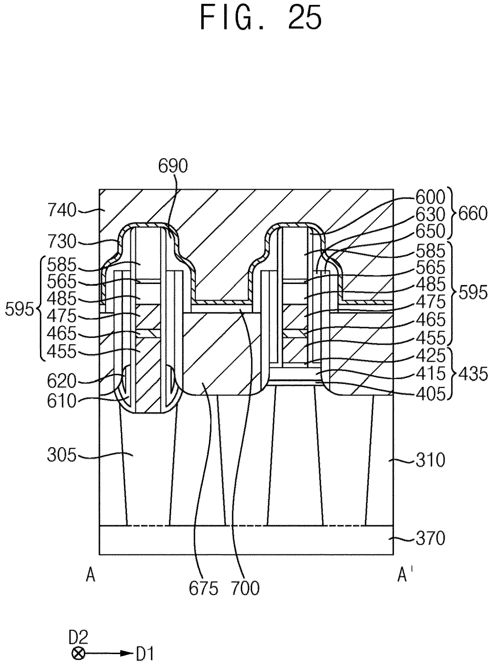

Referring to FIG. 25, a second barrier layer 730 may be formed on the third capping pattern 585, the fence pattern 685, the fourth spacer 690, the metal silicide pattern 700, and the lower contact plug 675, and a second metal layer 740 may be formed on the second barrier layer 730 to fill a space between the bit line structures 595.

A planarization process may be further performed on an upper portion of the second metal layer 740. The planarization process may include a CMP process and/or an etch back process.

Referring to FIGS. 26 and 27, the second metal layer 740 and the second barrier layer 730 may be patterned to form an upper contact plug 755, and a sixth opening 760 may be formed between the upper contact plugs 755.

The sixth opening 760 may be formed by partially removing the third capping pattern 585, the fence pattern 685, the preliminary spacer structure 660, and the fourth spacer 690 as well as the second metal layer 740 and the second barrier layer 730.

The upper contact plug 755 may include a second metal pattern 745 and a second barrier pattern 735 covering a lower surface of the second metal pattern 745. In example embodiments, the upper contact plug 755 may have a shape of, e.g., a circle, an ellipse, a polygon, a polygon with rounded corners, etc., and may be arranged in a honeycomb pattern in the first and second directions D1 and D2.

The lower contact plug 675, the metal silicide pattern 700, and the upper contact plug 755 sequentially stacked may collectively form a contact plug structure.

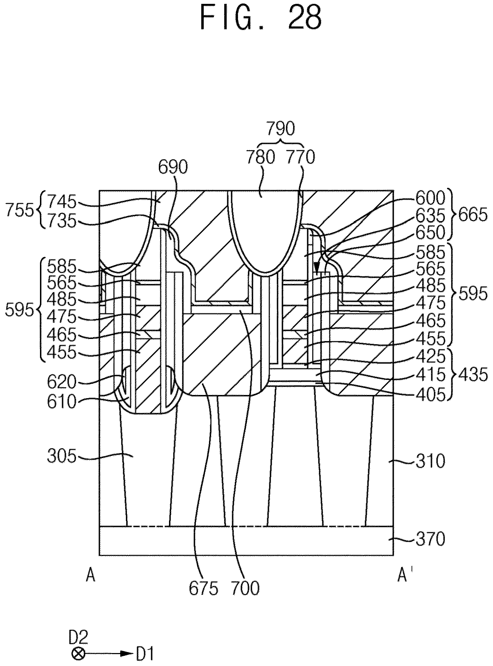

Referring to FIG. 28, the second spacer 630 included in the preliminary spacer structure 660 exposed by the sixth opening 760 may be removed to form an air gap, a sixth insulation pattern 770 may be formed on a bottom and a sidewall of the sixth opening 760, and a seventh insulation pattern 780 may be formed to fill a remaining portion of the sixth opening 760.

The sixth and seventh insulation patterns 770 and 780 may form a second insulation pattern structure 790.

A top of the air gap may be covered by the sixth insulation pattern 770, and thus an air spacer 635 may be formed. The first spacer 600, the air spacer 635, and the third spacer 650 may collectively form a spacer structure 665.

Referring to FIGS. 6 to 8 again, a second etch stop layer 810 and a mold layer may be sequentially stacked on the upper contact plug 755 and the second insulation pattern structure 790, the mold layer and the second etch stop layer 810 may be partially removed to form a seventh opening exposing an upper surface of the upper contact plug 755, and a lower electrode 820 may be formed in the seventh opening.

The mold layer may be removed, a dielectric layer 830 may be formed on a surface of the lower electrode 820, and an upper electrode 840 may be formed on a dielectric layer 830 to form a capacitor 850.

Upper wirings may be further formed to complete the fabrication of the semiconductor device.

The foregoing is illustrative of example embodiments and is not to be construed as limiting thereof. Although a few example embodiments have been described, those skilled in the art will readily appreciate that many modifications are possible in the example embodiments without materially departing from the novel teachings and advantages of the present inventive concept.

Examples of the present disclosure are set out in the following numbered clauses:
1. A gate structure comprising:
   a first conductive pattern;
   a second conductive pattern on the first conductive pattern, the second conductive pattern including polysilicon doped with impurities; and
   a gate insulation pattern on sidewalls of the first and second conductive patterns,
   wherein a capping layer is disposed under the first conductive pattern, the capping layer including a semiconductor material or an insulating material,
   wherein the first conductive pattern includes metal grains, and
   wherein at least one of the metal grains extends from an upper surface of the capping layer to a lower surface of the second conductive pattern, and contacts the upper surface of the capping layer and the lower surface of the second conductive pattern.
2. The gate structure according to clause 1,
   wherein the capping layer includes a protrusion portion, and
   wherein the first conductive pattern contacts an upper surface of the protrusion portion of the capping layer.
3. The gate structure according to clause 2, wherein the gate insulation pattern contacts a sidewall of the protrusion portion of the capping layer.
4. The gate structure according to any preceding clause,
   wherein an active pattern is formed on the capping layer, the active pattern including a semiconductor material, and
   wherein the gate insulation pattern extends through and contacts the active pattern.
5. The gate structure according to clause 4, wherein a lower surface of the first conductive pattern is substantially coplanar with a lower surface of the active pattern.
6. The gate structure according to any preceding clause, further comprising:
   a capping pattern on the second conductive pattern, the capping pattern including an insulating nitride.
7. The gate structure according to any preceding clause, wherein a width in a horizontal direction of the first conductive pattern gradually decreases from a bottom toward a top thereof.
8. The gate structure according to any preceding clause, wherein the first conductive pattern includes a metal, a metal nitride, or a metal silicon nitride.
9. A gate structure comprising:
   a first conductive pattern;
   a second conductive pattern on the first conductive pattern, the second conductive pattern including polysilicon doped with impurities; and
   a gate insulation pattern on sidewalls of the first and second conductive patterns,
   wherein a capping layer is disposed under the first conductive pattern, the capping layer including a semiconductor material or an insulating material, and
   wherein a lower surface of the first conductive pattern contacts an upper surface of a protrusion portion of the capping layer.
10. The gate structure according to clause 9, wherein the gate insulation pattern contacts a sidewall of the protrusion portion of the capping layer.
11. The gate structure according to clause 9 or clause 10,
   wherein an active pattern is formed on the capping layer, the active pattern including a semiconductor material, and
   wherein the gate insulation pattern extends through and contacts the active pattern.
12. The gate structure according to any of clauses 9 to 11, further comprising:
   a capping pattern on the second conductive pattern, the capping pattern including an insulating nitride.
13. The gate structure according to any of clauses 9 to 12, wherein a width in a horizontal direction of the first conductive pattern gradually decreases from a bottom toward a top thereof.
14. The gate structure according to any of clauses 9 to 13, wherein the first conductive pattern includes a metal grain, the metal grain extending from an upper surface of the protrusion portion of the capping layer to a lower surface of the second conductive pattern, and contacting the upper surface of the protrusion portion of the capping layer and the lower surface of the second conductive pattern.
15. The gate structure according to clause 14, wherein the first conductive pattern includes only a single metal grain.
16. The gate structure according to clause 14 or clause 15,
   wherein the first conductive pattern includes a plurality of metal grains, the metal grain being one of the plurality of metal grains, and
   wherein at least one of the plurality of metal grains extends from the upper surface of the protrusion portion of the capping layer to the lower surface of the second conductive pattern, and contacts the upper surface of the protrusion portion of the capping layer and the lower surface of the second conductive pattern.
17. A semiconductor device comprising:
   an active pattern on a capping layer, the capping layer including a semiconductor material or an insulating material;
   a gate structure in an upper portion of the active pattern, the gate structure extending in a first direction substantially parallel to a lower surface of the capping layer;
   a bit line structure extending in a second direction substantially parallel to the lower surface of the capping layer and substantially perpendicular to the lower surface of the capping layer, the bit line structure being on a central portion of the active pattern;
   a contact plug structure on each of opposite edge portions of the active pattern; and
   a capacitor structure on the contact plug structure,
   wherein the gate structure includes:
      a first conductive pattern;
      a second conductive pattern on the first conductive pattern, the second conductive pattern including polysilicon doped with impurities;
      a capping pattern on the second conductive pattern; and
      a gate insulation pattern on sidewalls of the first and second conductive patterns,
   wherein the first conductive pattern includes metal grains, and
   wherein at least one of the metal grains extends from an upper surface of the capping layer to a lower surface of the second conductive pattern, and contacts the upper surface of the capping layer and the lower surface of the second conductive pattern.
18. The semiconductor device according to clause 17,
   wherein the capping layer includes a protrusion portion, and
   wherein the first conductive pattern contacts an upper surface of the protrusion portion of the capping layer.
19. The semiconductor device according to clause 18, wherein the gate insulation pattern contacts a sidewall of the protrusion portion of the capping layer.
20. The semiconductor device according to any of clauses 17 to 19, wherein a lower surface of the first conductive pattern is substantially coplanar with a lower surface of the active pattern.
21. A method of forming a gate structure, the method comprising:
   forming a first recess on a substrate;
   forming a gate insulation layer on a bottom and a sidewall of the first recess;
   forming a first conductive pattern on the gate insulation layer in a lower portion of the first recess;
   forming a second conductive pattern on the first conductive pattern by a deposition process using the first conductive pattern as a seed;
   after overturning the substrate, removing an upper portion of the substrate and an upper portion of the gate insulation layer to expose the first conductive pattern; and
   removing the first conductive pattern.
22. The method according to clause 21, wherein the second conductive pattern is deposited from an upper surface of the first conductive pattern in a vertical direction substantially perpendicular to an upper surface of the substrate.
23. The method according to clause 21 or clause 22, wherein forming the second conductive pattern includes:
   forming a second conductive layer on the first conductive pattern; and
   removing an upper portion of the second conductive layer.
24. The method according to clause 23, further comprising:
   removing an upper portion of the substrate to form a second recess such that an active pattern is defined on the substrate; and
   forming an isolation pattern in the second recess,
   wherein forming the first recess on the substrate includes removing upper portions of the active pattern and the isolation pattern to form the first recess, and
   wherein removing the upper portion of the substrate and the upper portion of the gate insulation layer to expose the first conductive pattern includes removing upper portions of the active pattern and the isolation pattern and an upper portion of the gate insulation pattern to expose the first conductive pattern.
25. The method according to clause 24, wherein removing the upper portion of the second conductive layer includes:
   performing a chemical mechanical polishing (CMP) process on the second conductive layer until upper surfaces of the active pattern and the isolation pattern are exposed; and
   performing an etch back process on the second conductive layer such that the second conductive pattern is formed in a middle portion of the first recess.
26. The method according to clause 24 or clause 25, wherein removing the upper portion of the second conductive layer includes:
   performing a chemical mechanical polishing (CMP) process on the second conductive layer until upper surfaces of the active pattern and the isolation pattern are exposed such that an upper surface of the second conductive pattern is substantially coplanar with the upper surfaces of the active pattern and the isolation pattern.
27. The method according to any of clauses 24 to 26,
   wherein forming the gate insulation layer on the bottom and the sidewall of the first recess includes forming the gate insulation layer on the bottom and the sidewall of the first recess and upper surfaces of the active pattern and the isolation pattern,
   wherein forming the first conductive pattern on the gate insulation layer in the lower portion of the first recess includes:
      forming a first conductive layer on the gate insulation layer to fill the first recess;
      performing a chemical mechanical polishing (CMP) process on the first conductive layer until a portion of the gate insulation layer on the upper surfaces of the active pattern and the isolation pattern is removed to form a gate insulation pattern; and
      performing an etch back process on the first conductive layer to form a first conductive pattern in the lower portion of the first recess, and
   wherein removing the upper portions of the active pattern and the isolation pattern and the upper portion of the gate insulation layer to expose the first conductive pattern includes removing the upper portions of the active pattern and the isolation pattern and an upper portion of the gate insulation pattern to expose the first conductive pattern.
28. The method according to any of clauses 24 to 27, further comprising:
   after forming the second conductive pattern on the first conductive pattern, forming a capping layer on the second conductive pattern, the active pattern, and the isolation pattern.
29. The method according to any of clauses 21 to 28,
   wherein removing the first conductive pattern includes forming a second recess to expose an upper surface of the second conductive pattern, and
   wherein the method further comprises:
      forming a third conductive pattern in a lower portion of the second recess; and
      forming a capping pattern in an upper portion of the second recess.
30. A method of forming a gate structure, the method comprising:
   forming a first recess on a substrate;
   forming a gate insulation layer on a bottom and a sidewall of the first recess;
   forming a first conductive pattern on the gate insulation layer in a lower portion of the first recess;
   forming a second conductive pattern on the first conductive pattern in a middle portion of the first recess by a deposition process using the first conductive pattern as a seed;
   forming a capping layer on the second conductive pattern in an upper portion of the first recess, the capping layer including a semiconductor material;
   partially removing the substrate and the gate insulation layer to expose the first conductive pattern; and
   removing the first conductive pattern.
31. The method according to clause 30, further comprising:
   removing an upper portion of the substrate to form a second recess such that an active pattern is defined on the substrate; and
   forming an isolation pattern in the second recess,
   wherein forming the first recess on the substrate includes removing upper portions of the active pattern and the isolation pattern to form the first recess, and
   wherein removing the upper portion of the substrate and the upper portion of the gate insulation layer to expose the first conductive pattern includes partially removing the active pattern, the isolation pattern, and the gate insulation pattern to expose the first conductive pattern.
32. The method according to clause 31, wherein forming the capping layer on the second conductive pattern in the upper portion of the first recess includes forming the capping layer on the second conductive pattern, the active pattern, and the isolation pattern.
33. The method according to clause 31 or 32, wherein forming the second conductive pattern on the first conductive pattern in the middle portion of the first recess includes:
   forming a second conductive layer on the first conductive pattern;
   performing a chemical mechanical polishing (CMP) process on the second conductive layer until upper surfaces of the active pattern and the isolation pattern are exposed; and
   performing an etch back process on the second conductive layer such that the second conductive pattern is formed in the middle portion of the first recess.
34. The method according to any of clauses 31 to 33,
   wherein forming the gate insulation layer on the bottom and the sidewall of the first recess includes forming the gate insulation layer on the bottom and the sidewall of the first recess and upper surfaces of the active pattern and the isolation pattern,
   wherein forming the first conductive pattern on the gate insulation layer in the lower portion of the first recess includes:
      forming a first conductive layer on the gate insulation layer to fill the first recess;
      performing a chemical mechanical polishing (CMP) process on the first conductive layer until a portion of the gate insulation layer on the upper surfaces of the active pattern and the isolation pattern is removed to form a gate insulation pattern; and
      performing an etch back process on the first conductive layer to form a first conductive pattern in the lower portion of the first recess, and
   wherein partially removing the active pattern, the isolation pattern, and the gate insulation layer to expose the first conductive pattern includes partially removing the active pattern, the isolation pattern, and the gate insulation pattern to expose the first conductive pattern.
35. The method according to any of clauses 30 to 34,
   wherein removing the first conductive pattern includes forming a second recess to expose an upper surface of the second conductive pattern, and
   wherein the method further comprises:
      forming a third conductive pattern in a lower portion of the second recess; and
      forming a capping pattern in an upper portion of the second recess.
36. The method according to any of clauses 30 to 35, wherein the second conductive pattern is deposited on an upper surface of the first conductive pattern in a vertical direction substantially perpendicular to an upper surface of the substrate.
37. A method of manufacturing a semiconductor device, the method comprising:
   removing an upper portion of a substrate to form a first recess such that an active pattern is defined on the substrate;
   forming an isolation pattern in the first recess;
   removing upper portions of the active pattern and the isolation pattern to form a second recess;
   forming a gate insulation layer on a bottom and a sidewall of the second recess;
   forming a first conductive pattern on the gate insulation layer in a lower portion of the second recess;
   forming a second conductive pattern on the first conductive pattern by a deposition process using the first conductive pattern as a seed;
   after overturning the substrate, removing an upper portion of the substrate and an upper portion of the gate insulation layer to expose the first conductive pattern;
   removing the first conductive pattern to form a third recess;
   sequentially forming a third conductive pattern and a capping pattern in the third recess;
   forming a bit line structure electrically connected to a first portion of the active pattern; and
   forming a capacitor electrically connected to a second portion of the active pattern.
38. The method according to clause 37, further comprising:
   forming a contact plug structure that contacts the second portion of the active pattern,
   wherein the capacitor is formed to contact the contact plug structure.
39. The method according to clause 37 or clause 38, wherein the second conductive pattern is deposited on an upper surface of the first conductive pattern in a vertical direction substantially perpendicular to an upper surface of the substrate.
40. The method according to any of clauses 37 to 39, further comprising:
   after forming the second conductive pattern on the first conductive pattern, forming a capping layer on the second conductive pattern, the active pattern and the isolation pattern.

## Claims

1. A gate structure comprising:
a first conductive pattern;
a second conductive pattern on the first conductive pattern, the second conductive pattern including polysilicon doped with impurities; and
a gate insulation pattern on sidewalls of the first and second conductive patterns,
wherein a capping layer is disposed under the first conductive pattern, the capping layer including a semiconductor material or an insulating material,
wherein the first conductive pattern includes metal grains, and
wherein at least one of the metal grains extends from an upper surface of the capping layer to a lower surface of the second conductive pattern, and contacts the upper surface of the capping layer and the lower surface of the second conductive pattern.

2. The gate structure according to claim 1,
wherein the capping layer includes a protrusion portion, and
wherein the first conductive pattern contacts an upper surface of the protrusion portion of the capping layer.

3. The gate structure according to claim 2, wherein the gate insulation pattern contacts a sidewall of the protrusion portion of the capping layer.

4. The gate structure according to any preceding claim,
wherein an active pattern is formed on the capping layer, the active pattern including a semiconductor material, and
wherein the gate insulation pattern extends through and contacts the active pattern.

5. The gate structure according to claim 4, wherein a lower surface of the first conductive pattern is substantially coplanar with a lower surface of the active pattern.

6. The gate structure according to any preceding claim, further comprising:
a capping pattern on the second conductive pattern, the capping pattern including an insulating nitride.

7. The gate structure according to any preceding claim, wherein a width in a horizontal direction of the first conductive pattern gradually decreases from a bottom toward a top thereof.

8. The gate structure according to any preceding claim, wherein the first conductive pattern includes a metal, a metal nitride, or a metal silicon nitride.

9. A gate structure comprising:
a first conductive pattern;
a second conductive pattern on the first conductive pattern, the second conductive pattern including polysilicon doped with impurities; and
a gate insulation pattern on sidewalls of the first and second conductive patterns,
wherein a capping layer is disposed under the first conductive pattern, the capping layer including a semiconductor material or an insulating material, and
wherein a lower surface of the first conductive pattern contacts an upper surface of a protrusion portion of the capping layer.

10. The gate structure according to claim 9, wherein the gate insulation pattern contacts a sidewall of the protrusion portion of the capping layer.

11. The gate structure according to claim 9 or claim 10,
wherein an active pattern is formed on the capping layer, the active pattern including a semiconductor material, and
wherein the gate insulation pattern extends through and contacts the active pattern.

12. A semiconductor device comprising:
an active pattern on a capping layer, the capping layer including a semiconductor material or an insulating material;
a gate structure in an upper portion of the active pattern, the gate structure extending in a first direction substantially parallel to a lower surface of the capping layer;
a bit line structure extending in a second direction substantially parallel to the lower surface of the capping layer and substantially perpendicular to the lower surface of the capping layer, the bit line structure being on a central portion of the active pattern;
a contact plug structure on each of opposite edge portions of the active pattern; and
a capacitor structure on the contact plug structure,
wherein the gate structure includes:
a first conductive pattern;
a second conductive pattern on the first conductive pattern, the second conductive pattern including polysilicon doped with impurities;
a capping pattern on the second conductive pattern; and
a gate insulation pattern on sidewalls of the first and second conductive patterns,
wherein the first conductive pattern includes metal grains, and
wherein at least one of the metal grains extends from an upper surface of the capping layer to a lower surface of the second conductive pattern, and contacts the upper surface of the capping layer and the lower surface of the second conductive pattern.

13. The semiconductor device according to claim 12,
wherein the capping layer includes a protrusion portion, and
wherein the first conductive pattern contacts an upper surface of the protrusion portion of the capping layer.

14. The semiconductor device according to claim 13, wherein the gate insulation pattern contacts a sidewall of the protrusion portion of the capping layer.

15. The semiconductor device according to any of claims 12 to 14, wherein a lower surface of the first conductive pattern is substantially coplanar with a lower surface of the active pattern.
